# EUROPEAN PATENT APPLICATION

(11) **EP 4 545 614 A1**
(43) Date of publication of application: **30.04.2025**
(21) Application number: 24208133.9
(22) Date of filing: 22.10.2024
(51) Int. Cl.: C09G 1/02, C09K 3/14

(54) **POLISHING SLURRY AND METHOD OF MANUFACTURING SEMICONDUCTOR DEVICE**

(30) Priority: 24.10.2023 KR 20230142810; 21.10.2024 KR 20240144114
(71) Applicant: Samsung Electronics Co., Ltd, Suwon-si, Gyeonggi-do 16677 (KR)
(72) Inventor: KO, Yoonseok, 16678 Suwon-si (KR); LEE, Jung Hoon, 16678 Suwon-si (KR); JEE, Sang Soo, 16678 Suwon-si (KR); KALININA, Fedosya, 16678 Suwon-si (KR); LEE, Hyune Jea, 16678 Suwon-si (KR)
(74) Representative: Elkington and Fife LLP

(57) **Abstract**

A polishing slurry, and a method of manufacturing a semiconductor device using the polishing slurry are provided. The polishing slurry includes nano-abrasive particles having a Mohs hardness greater than about 5, and soft particles having a Mohs hardness lower than the Mohs hardness of the nano-abrasive particles, and wherein the nano-abrasive particles and the soft particles have a same sign of zeta potentials as each other in the polishing slurry.

## Description

### FIELD OF THE INVENTION

Example embodiments relate to polishing slurries, and methods of manufacturing semiconductor devices using the same.

### BACKGROUND OF THE INVENTION

A semiconductor device requires a structure with a flat surface during the manufacturing process. This structure may be formed by a polishing process. The polishing process may include chemical mechanical polishing (CMP). The chemical mechanical polishing includes providing a polishing slurry containing abrasive particles between the substrate to be polished and the polishing pad, while rotating the semiconductor substrate in contact with the polishing pad to planarize the surface of the semiconductor substrate by pressing and rotating it.

Recently, high-performance and highly integrated semiconductor devices require fine pitch structures. Fine abrasive particles with a very small particle size range are being studied to effectively polish fine pitch structures. However, when fine abrasive particles are used, the polishing rate tends to be lower. Therefore, there is a need for a new method that can achieve both effective polishing of fine pitch structures and improvement in polishing rate.

### SUMMARY OF THE INVENTION

Some example embodiments provide a novel polishing slurry that can simultaneously improve polishing rate and effectiveness while reducing structural damage and shape deformation, such as surface scratches.

Some example embodiments provide a method of manufacturing a semiconductor device using the polishing slurry.

The polishing slurry according to some example embodiments may include nano-abrasive particles having a Mohs hardness greater than about 5, and soft particles having a Mohs hardness lower than the Mohs hardness of the nano-abrasive particles, wherein the nano-abrasive particles and the soft particles in the polishing slurry have a same sign of zeta potentials as each other.

The soft particles may include polymer particles.

A difference in Mohs hardness between the Mohs hardness of the soft particles and the Mohs hardness of the nano-abrasive particles may be greater than or equal to about 1.

The soft particles may have a larger average particle size than the nano-abrasive particles.

An average particle diameter of the nano-abrasive particles may be less than or equal to about 100 nanometers.

An average particle diameter of the soft particles may be about 50 nm to about 20 µm.

The nano-abrasive particles and the soft particles in the slurry may have a same zeta potential as each other.

The soft particles may include polystyrene, a styrene-based copolymer, poly(alkyl)(meth)acrylate, an acrylic copolymer, polyvinyl chloride, polyacetal, saturated polyester, polyamide, polyimide, poly(amide-imide) copolymer, polycarbonate, a phenoxy resin, polyolefin, an olefin-based copolymer, polyurea, polyurethane, a melamine resin, an epoxy resin, or any combination thereof.

The nano-abrasive particles may include a metal oxide, a metal nitride, a metal fluoride, a metal carbide, or any combination thereof.

The metal oxide may include silicon oxide, cerium oxide, titanium oxide, zirconium oxide, aluminum oxide, molybdenum oxide, ruthenium oxide, tantalum oxide, tungsten oxide, or any combination thereof, the metal nitride may include silicon nitride, aluminum nitride, titanium nitride, boron nitride (cubic structure), or any combination thereof, the metal fluoride may include calcium fluoride (CaF₂), selenium fluoride (SeF₄), tellurium fluoride (TeF₄), or any combination thereof, and the metal carbide may include tantalum carbide, boron carbide, or any combination thereof.

The soft particles may be included in the polishing slurry in an amount of about 0.01 weight percent (wt%) to about 15 wt%, and the nano-abrasive particles may be included in the polishing slurry in an amount of about 0.01 wt% to about 15 wt%, based on the total weight of the polishing slurry.

The soft particles and the nano-abrasive particles may be present in the slurry in a weight ratio of about 0.1:1 to about 5:1.

The soft particles and the nano-abrasive particles may be present in the slurry in a volume ratio of about 1:1 to about 30:1.

The soft particles may be spherical.

In the polishing slurry, both the soft particles and the nano-abrasive particles may have positive zeta potentials, or both the soft particles and the nano-abrasive particles may have negative zeta potentials.

The polishing slurry may further include a chelating agent, an oxidizing agent, a surfactant, a dispersant, a pH adjusting agent, or any combination thereof.

A method of manufacturing a semiconductor device according to some example embodiments may include arranging a surface of a semiconductor substrate and a surface of a polishing pad proximate to each other, supplying the polishing slurry according to some example embodiments between the semiconductor substrate and the polishing pad, and polishing the surface of the semiconductor substrate based on contacting the surface of the semiconductor substrate with the surface of the polishing pad.

The supplying of the polishing slurry according to some example embodiments may include supplying the polishing slurry between the semiconductor substrate and the polishing pad at a rate of about 10 milliliter per minute (ml/min) to about 300 ml/min.

The polishing of the surface of the semiconductor substrate may be conducted concurrently with a pressure being applied to the surface of the semiconductor substrate, the pressure being about 1 psi to about 10 psi.

The polishing slurry may polish metal wire present at the surface of the semiconductor substrate. Accordingly, the semiconductor substrate may include metal wire at the surface of the semiconductor substrate, and the polishing of the surface of the semiconductor substrate may include polishing the metal wire.

The polishing slurry according to some example embodiments may improve polishing rate and polishing efficiency, and optionally reduce or minimize surface damage such as surface scratches and shape deformation of fine pitch structures. As a result, a semiconductor device having a high-performance, highly integrated semiconductor device including a structure having a fine pitch of about 10 nm or less with reduced, minimized, or absence of defects may be manufactured based on one or more surfaces of the semiconductor device (e.g., a semiconductor wafer) being polished using the polishing slurry. The polishing slurry is easy to manufacture and uses inexpensive materials, and thus manufacturing costs are also low. Accordingly, the use of the polishing slurry in a polishing process, for example to polish a semiconductor wafer may reduce manufacturing costs to manufacture semiconductor devices using structures having one or more surfaces polished using the polishing slurry.

### BRIEF DESCRIPTION OF THE DRAWINGS

FIG. 1 is a schematic view schematically showing the operating principle of a polishing slurry according to some example embodiments.
FIGS. 2, 3, 4, 5, 6, 7, and 8 are cross-sectional views showing the manufacturing process of shallow trench isolation (STI) according to some example embodiments.
FIG. 9 is a schematic view schematically showing example chemical mechanical polishing equipment according to some example embodiments.
FIG. 10 is a graph showing the polishing rates of two slurries including ceria particles alone with each different particle sizes, and a slurry including soft polymer particles alone, according to Reference Example 1, respectively.
FIG. 11 is a graph showing the polishing rates of three slurries in which two slurries (A and B) including ceria and different types of polystyrene with the same zeta potential sign as ceria, respectively, according to Example 1, and a slurry including ceria with a size of 25 nm alone (STD: standard).
FIG. 12 is a graph showing the polishing rates of three slurries including two slurries (A and B) including ceria and different types of polystyrene with the same zeta potential sign as ceria, respectively, according to Example 2, and a slurry including ceria with a size of 15 nm alone (STD: standard).
FIG. 13 is a graph showing the polishing rate of two slurries including one slurry including silica and a polymer having the same sign of zeta potential as silica (A), according to Example 3, and the other slurry including only silica with a size of 7 nm (Silica).
FIG. 14 is a graph showing the polishing rates of five (5) slurries including polystyrene with the same sign of zeta potential as ceria in different amounts, according to Example 4, and a slurry including ceria alone with a size of 25 nm (STD: standard).
FIG. 15 is a graph showing the polishing rates of five (5) slurries including two slurries (Positive A and Positive B) including ceria and different types of polystyrene with the same zeta potential sign as ceria, respectively, two slurries (Negative A and Negative B) including ceria and different types of polystyrene with zeta potentials of the opposite sign to ceria, respectively, according to Example 5, and a slurry including ceria alone with a size of 25 nm.
FIG. 16 is a photograph of the Negative A slurry of FIG. 15.
FIG. 17 is a photograph of two bottles in which one (left) containing a mixture to which a polymer having the opposite zeta potential sign to the silica particles is added, and the other (right) containing a mixture to which a polymer having the same zeta potential sign as the silica particles is added.
FIG. 18 is a graph showing the polishing rates of a slurry (Negative) in which a polymer having the same zeta potential sign to that of silica is mixed, a slurry (Positive) in which a polymer having a zeta potential sign opposite to silica is mixed, as well as a slurry (Silica) including silica particles alone.
FIG. 19 shows photographs of the surfaces of semiconductor wafers polished with a slurry (left) including ceria alone with a particle size of 50 nm, a slurry (center) including ceria alone with a particle size of 25 nm, and a slurry (right) including ceria with a particle size of 25 nm and polystyrene with a particle size of 83 nm, measured using AFM (Atomic Force Microscopy).
FIG. 20 shows photographs measured with AFM of the surface of semiconductor wafers polished with a slurry (left) including silica alone with a particle size of 7 nm and a slurry (right) including the silica together with a polymer with a particle size of 100 nm.
FIG. 21 is a schematic block diagram of an electronic device according to some example embodiments.

### DETAILED DESCRIPTION

Hereinafter, some example embodiments are described in detail so that those of ordinary skill in the art can easily implement them. However, a structure that is actually applied may be implemented in various different forms, and is not limited to the example embodiments described herein.

The terminology used herein is used to describe some example embodiments only, and is not intended to limit the present inventive concepts. The singular expression includes the plural expression unless the context clearly dictates otherwise.

As used herein, "any combination thereof" refers to a mixture, a laminate, a composite, a copolymer, an alloy, a blend, a reaction product, and/or the like of constituents.

As used herein, "metal" may include a semi-metal as well as a metal.

As used herein, "Mohs hardness" is a relative value compared with reference materials (refer to https://en.wikipedia.org/wiki/Mohs_scale). A "Mohs hardness" as described herein may be a relative value of hardness compared with a reference material that is Talc (Mg₃Si₄O₁₀(OH)₂), where Talc has a Mohs hardness of 1.

Herein, it should be understood that terms such as "comprises," "includes," or "have" are intended to designate the presence of an embodied feature, number, step, element, or any combination thereof, but does not preclude the possibility of the presence or addition of one or more other features, number, step, element, or any combination thereof.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it may be directly on the other element or intervening elements may also be present. In contrast, when an element is referred to as being "directly on" another element, there are no intervening elements present.

In addition, the term "layer" as used herein includes not only a shape formed on the whole surface when viewed from a plan view, but also a shape formed on a partial surface.

As used herein, "size" means an average particle diameter in the case of a sphere and the length of the longest portion in the case of a non-spherical shape. The size may be measured by a method well known to those skilled in the art, for example, may be measured by a particle size analyzer, or may be measured by a transmission electron micrograph or a scanning electron micrograph. In some example embodiments, it is possible to obtain an average particle diameter value by measuring utilizing a dynamic light scattering method, performing data analysis, counting the number of particles for each particle size range, and calculating from these data. Unless otherwise defined, the average particle diameter may refer to the diameter (D50) of particles having a cumulative volume of 50 volume% in the particle size distribution. Also, when "size" or "particle size" is mentioned alone, it refers to "average particle size". The term "average" as used herein refers to the mean average.

In the present inventive concepts, the term "or" is not to be construed as an exclusive meaning, and for example, "A or B" is construed to include A, B, A+B, and/or the like.

As used herein, "at least one of A, B, or C," "one of A, B, C, or any combination thereof" and "one of A, B, C, and any combination thereof" refer to each constituent element, and any combination thereof (e.g., A; B; C; A and B; A and C; B and C; or A, B, and C).

It will be understood that elements and/or properties thereof (e.g., structures, surfaces, directions, or the like), which may be referred to as being "perpendicular," "parallel," "coplanar," or the like with regard to other elements and/or properties thereof (e.g., structures, surfaces, directions, or the like) may be "perpendicular," "parallel," "coplanar," or the like or may be "substantially perpendicular," "substantially parallel," "substantially coplanar," respectively, with regard to the other elements and/or properties thereof.

Elements and/or properties thereof (e.g., structures, surfaces, directions, or the like) that are "substantially perpendicular" with regard to other elements and/or properties thereof will be understood to be "perpendicular" with regard to the other elements and/or properties thereof within manufacturing tolerances and/or material tolerances and/or have a deviation in magnitude and/or angle from "perpendicular," or the like with regard to the other elements and/or properties thereof that is equal to or less than 10% (e.g., a. tolerance of ±10%). Elements and/or properties thereof (e.g., structures, surfaces, directions, or the like) that are "substantially parallel" with regard to other elements and/or properties thereof will be understood to be "parallel" with regard to the other elements and/or properties thereof within manufacturing tolerances and/or material tolerances and/or have a deviation in magnitude and/or angle from "parallel," or the like with regard to the other elements and/or properties thereof that is equal to or less than 10% (e.g., a. tolerance of ±10%).

Elements and/or properties thereof (e.g., structures, surfaces, directions, or the like) that are "substantially coplanar" with regard to other elements and/or properties thereof will be understood to be "coplanar" with regard to the other elements and/or properties thereof within manufacturing tolerances and/or material tolerances and/or have a deviation in magnitude and/or angle from "coplanar," or the like with regard to the other elements and/or properties thereof that is equal to or less than 10% (e.g., a. tolerance of ±10%).

It will be understood that elements and/or properties thereof may be recited herein as being "the same" or "equal" as other elements, and it will be further understood that elements and/or properties thereof recited herein as being "identical" to, "the same" as, or "equal" to other elements may be "identical" to, "the same" as, or "equal" to or "substantially identical" to, "substantially the same" as or "substantially equal" to the other elements and/or properties thereof.

Elements and/or properties thereof that are "substantially identical" to, "substantially the same" as or "substantially equal" to other elements and/or properties thereof will be understood to include elements and/or properties thereof that are identical to, the same as, or equal to the other elements and/or properties thereof within manufacturing tolerances and/or material tolerances. Elements and/or properties thereof that are identical or substantially identical to and/or the same or substantially the same as other elements and/or properties thereof may be structurally the same or substantially the same, functionally the same or substantially the same, and/or compositionally the same or substantially the same.

It will be understood that elements and/or properties thereof described herein as being the "substantially" the same and/or identical encompasses elements and/or properties thereof that have a relative difference in magnitude that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof. While the term "same," "equal" or "identical" may be used in description of some example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about" is used in this specification in connection with a numerical value, it is intended that the associated numerical value includes a manufacturing or operational tolerance (e.g., ±10%) around the stated numerical value. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

As described herein, when an operation is described to be performed, or an effect such as a structure is described to be established "by" or "through" performing additional operations, it will be understood that the operation may be performed and/or the effect/structure may be established "based on" the additional operations, which may include performing said additional operations alone or in combination with other further additional operations.

Advanced high-performance highly integrated semiconductor devices require fine pitch structures of about 10 nm or less. Conventional abrasive slurries including abrasive particles with a particle size of several tens of nanometers may cause damage to fine pitch structures, such as surface scratches and shape deformation. Accordingly, in order to effectively polish fine pitch structures, fine abrasive particles with a particle size of several nanometers are of interest and are being studied rather than the existing abrasive particles with a particle size of tens of nanometers. However, these fine abrasive particles have a low or inefficient polishing rate, and therefore, improvement in polishing performance is needed and sought.

A traditional method is to increase the size of the abrasive particles to increase the removal rate (RR), but this causes many scratches and defects on the surface of the semiconductor device. In addition, it is not appropriate to use large-sized abrasive particles for polishing high-performance, highly integrated semiconductor devices that require fine pitch structures of about 10 nm or less.

Another method to increase the polishing rate is to synthesize new shaped or functional abrasive particles. However, this is cumbersome as it requires multiple synthesis steps, and of the related time and labor consumption.

One method for inducing a strong chemical bond between ceria and SiO₂ on the semiconductor surface may be by controlling the ion valence of the ceria surface, that is, a Ce³⁺/Ce⁴⁺ ratio. However, controlling the ion valence of the ceria surface generally requires a high-temperature reduction reaction using hydrogen, which has a high temperature and risk of explosion, or doping with expensive transition metal or noble metal atoms.

The polishing slurry according to some example embodiments does not suffer any of the problems of existing methods and can be easily manufactured with inexpensive materials. In addition, excellent polishing effect and significantly improved polishing rate can be achieved when performing a polishing process using the prepared polishing slurry in accordance with some example embodiments.

Specifically, the polishing slurry according to some example embodiments includes soft particles having a Mohs hardness of less than or equal to about 5, and nano-abrasive particles, wherein in the slurry, the soft particles and the nano-abrasive particles have zeta potentials of the same sign.

That is, the polishing slurry according to some example embodiments includes, in addition to nano-sized abrasive particles, soft particles that do not directly participate in polishing because their Mohs hardness is significantly lower than that of the material to be polished, such as SiO₂, which forms a semiconductor material, and the soft particles and the abrasive particles have zeta potentials of the same sign in the slurry, so that the particles do not form aggregates in the slurry, improving the polishing rate of nano-sized abrasive particles, and reducing surface defects of the material to be polished.

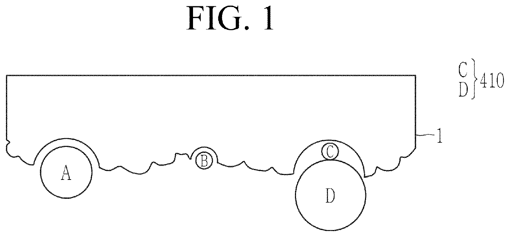

The operating principle of the polishing slurry according to some example embodiments will be described with reference to FIG. 1.

FIG. 1 is a schematic view schematically showing the operating principle of a polishing slurry 410 according to some example embodiments. FIG. 1 is a schematic view schematically showing the case of polishing the surface of a material to be polished, for example, a semiconductor wafer 1, using abrasive particles having a Mohs hardness of greater than about 5, respectively, indicated by A, B, and C, and soft particles D having a Mohs hardness lower than the abrasive particles.

As shown in FIG. 1, when the surface of the semiconductor wafer 1 is polished using abrasive particles A and abrasive particles B, respectively, in proportion to the size of the abrasive particles, the polishing rate is higher when polishing is performed by using abrasive particles A having a larger particle size than abrasive particles B having a smaller particle size. In the case of abrasive particles B having a small particle size, not only is the contact area with the surface of the semiconductor wafer 1 small, but also the load transmitted from the polishing head is not sufficiently transmitted, resulting in a much lower polishing rate compared to abrasive particles A. For example, when the size of the abrasive particles is reduced from about 100 nm to about 22 nm, the polishing rate can be reduced by about 80% or more.

On the other hand, the larger the abrasive particles, the larger the size of the surface scratch of the material to be polished. That is, the size of the surface scratch is proportional to the size of the abrasive particles. Therefore, in order to reduce surface scratches, abrasive particles having a smaller particle size must be used. In this case, the problem of reducing the polishing rate as described above should be solved.

In FIG. 1, abrasive particles C are shown to polish the surface of the semiconductor wafer 1 while in contact with soft particles D. As described above, the soft particles D are made of a material whose Mohs hardness is lower than that of the abrasive particles, and are substantially a material that cannot polish the surface of the semiconductor wafer 1 alone. However, as shown in FIG. 1, when the soft particles D are in contact with the abrasive particles C, a load applied from a polishing head may be well transmitted to the abrasive particles C through the soft particles D. In this case, even if the abrasive particles C have a small particle size, the load may be better transmitted to the abrasive particles C through the soft particles D than the case of using the abrasive particles alone. That is, a much higher polishing rate may be obtained than using the abrasive particles B alone with the same particle size as the abrasive particles C. Herein, as schematically illustrated in FIG. 1, the soft particles D may be made to have a much larger particle size than the abrasive particles C, so that a higher load may be transmitted to the abrasive particles C, thereby achieving a higher polishing rate. At the same time, because the soft particles D themselves may not polish the surface of the semiconductor wafer 1, even if the soft particles D with a much larger particle size exist in the polishing slurry, there is almost no concern of increasing the scratches on the polishing object surface. In conclusion, the polishing slurry 410 according to some example embodiments includes soft particles D having no or substantially no polishing ability due to low Mohs hardness and nano-sized abrasive particles C (also referred to interchangeably herein as nano-sized abrasive particles, abrasive particles, or the like) together to achieve a surprising effect of improving a polishing rate as well as reducing surface scratches. As a result, a semiconductor device having a high-performance, highly integrated semiconductor device including a structure having a fine pitch of about 10 nm or less with reduced, minimized, or absence of defects may be manufactured based on one or more surfaces of the semiconductor device being polished using the polishing slurry 410.

In addition, the soft particles (e.g., soft particles D) and the abrasive particles (also referred to interchangeably herein as nano-abrasive particles, nano-sized abrasive particles, or the like), for example abrasive particles C, in the polishing slurry 410 according to some example embodiments have a zeta potential with the same sign (e.g., the zeta potential of the soft particles and the zeta potential of the abrasive particles are both positive zeta potentials or are both negative zeta potentials). As seen from examples and comparative examples to be described below, when the abrasive particles and the soft particles have a zeta potential with an opposite sign to each other, these two types of particles may be adsorbed to each other in the slurry due to electrostatic attraction between the particles, which may increase a particle size in the slurry and thus lead to precipitation. In other words, the particles having a zeta potential with different signs may be mixed and the absorbed to form precipitates in the slurry and thus make the slurry heterogenous, leading to a decrease in polishing efficiency of the slurry and/or a defect in polished products.

In the polishing slurry 410 according to some example embodiments, the soft particles (e.g., soft particles D) and the abrasive particles (e.g., abrasive particles C) may have a zeta potential with the same sign, having neither adsorption nor agglomeration between the particles due to electrostatic repulsion or no precipitation resulting therefrom. Accordingly, the polishing slurry 410 according to some example embodiments may maintain a homogeneous state or substantially homogenous state and exhibit effects of a high polishing rate and low surface scratch generation as described above. As a result, the performance of the polishing slurry 410 in facilitating polishing of a surface, with reduced, minimized, or prevented damage to the surface being polished may be improved, and a semiconductor device having a high-performance, highly integrated semiconductor device including a structure having a fine pitch of about 10 nm or less with reduced, minimized, or absence of defects may be manufactured based on one or more surfaces of the semiconductor device being polished using the polishing slurry 410.

As described herein, soft particles included in the polishing slurry 410 may include the soft particles D as shown in FIG. 1, and therefore descriptions herein that are directed to soft particles included in the polishing slurry 410 will be understood to be applicable to the soft particles D. As described herein, abrasive particles (also referred to herein interchangeably as nano-abrasive particles, nano-sized abrasive particles, or the like) included in the polishing slurry 410 may include the abrasive particles C as shown in FIG. 1, and therefore descriptions herein that are directed to abrasive particles, nano-abrasive particles, nano-sized abrasive particles, or the like included in the polishing slurry 410 will be understood to be applicable to the abrasive particles C.

The zeta potentials of soft particles and the abrasive particles may be changed according to pH of the polishing slurry 410. Accordingly, pH of the polishing slurry 410 according to some example embodiments may be adjusted and maintained within a range that the soft particles and the abrasive particles may have a zeta potential with the same sign in the polishing slurry 410. In some example embodiments, within a specific pH range, if specific abrasive particles have a positive or negative zeta potential, a soft particle material having the same positive or negative zeta potential (e.g., the soft particle material having a zeta potential with a same sign as the zeta position of the specific abrasive particles) may be selected and combined therewith. In some example embodiments, chemical structures of materials forming the soft particles and/or the abrasive particles may be changed, or the surface of the particles may be modified by a specific functional group, so that each of these two particles may have a positive or negative zeta potential within a specific pH range. Various methods for changing zeta potentials of specific materials are well known to those skilled in the art. Those skilled in the art may select an appropriate method to adjust the soft particles and the abrasive particles in the polishing slurry 410 according to some example embodiments to have a zeta potential with the same sign.

In some example embodiments, the pH of the polishing slurry 410 may be adjusted to a range of about 2 to about 9, for example, a pH range of about 3 to about 8, a pH range of about 3 to about 7, or a range of about 4 to about 6, and both the soft particles and the abrasive particles included in the polishing slurry 410 may be selected from soft particles and abrasive particles having a positive zeta potential. In some example embodiments, the pH of the polishing slurry 410 may be adjusted to the above range, and the soft particles and the abrasive particles included in the polishing slurry 410 may be selected from the soft particles and abrasive particles both having a zeta potential with a negative sign (e.g., a negative zeta potential).

In some example embodiments, the soft particles and the abrasive particles included in the polishing slurry 410 may have the same zeta potential as each other. In this case, agglomeration between the soft particles and the abrasive particles may be more effectively reduced, minimized, or prevented, thereby synergistic effect of including a mixture of the soft particles and the abrasive particles having different sizes and different hardnesses may be increased or maximized. As a result, the performance of the polishing slurry 410 in facilitating polishing of a surface, with reduced, minimized, or prevented damage to the surface being polished may be improved.

As long as the soft particles have a zeta potential of the same sign as the nano-abrasive particles, for example, the same zeta potential as the nano-abrasive particles, in a certain pH range within the polishing slurry 410, have a lower Mohs hardness than the nano-abrasive particles, for example, a lower Mohs hardness than the material to be polished, having substantially no polishing ability itself, and have a larger particle size than the nano-abrasive particles, any material can be selected without limitation and used as the soft particles.

For example, the soft particles may have a Mohs hardness that is lower than the Mohs hardness of the abrasive particles, for example less than or equal to about 4.9, less than or equal to about 4.8, less than or equal to about 4.7, less than or equal to about 4.6, less than or equal to about 4.5, less than or equal to about 4.4, less than or equal to about 4.3, less than or equal to about 4.2, less than or equal to about 4.1, less than or equal to about 4.0, less than or equal to about 3.9, less than or equal to about 3.8, less than or equal to about 3.7, less than or equal to about 3.6, less than or equal to about 3.5, less than or equal to about 3.4, less than or equal to about 3.3, less than or equal to about 3.2, less than or equal to about 3.1, less than or equal to about 3.0, or less than or equal to about 2.5, and the soft particles may have a Mohs hardness that is greater than or equal to about 0.1, greater than or equal to about 0.2, greater than or equal to about 0.3, greater than or equal to about 0.4, or greater than or equal to about 0.5.

When having a Mohs hardness within the above range, the soft particles may not participate in the actual polishing process in a general chemical mechanical polishing process. This is because the Mohs hardness in the above range may be a lower level of Mohs hardness than the Mohs hardness of the polishing object to be polished. In some example embodiments, the soft particles should not participate in a substantial polishing process in a typical chemical mechanical polishing process.

The nano-abrasive particles may be any nano-abrasive particles used in the chemical mechanical polishing process, and for example, those having a Mohs hardness of greater than about 5 may be used. For example, the Mohs hardness of the nano-abrasive particles may be greater than or equal to about 5.5, greater than or equal to about 5.6, greater than or equal to about 5.7, greater than or equal to about 5.8, greater than or equal to about 5.9, greater than or equal to about 6.0, greater than or equal to about 6.1, greater than or equal to about 6.2, greater than or equal to about 6.3, greater than or equal to about 6.4, greater than or equal to about 6.5, or greater than or equal to about 7.0, and the Mohs hardness of the nano-abrasive particles may be less than or equal to about 10, for example, less than or equal to about 9. The nano-abrasive particles may have a Mohs hardness within the above range, and thus may participate in a practical polishing process within the polishing slurry 410 according to some example embodiments.

In the polishing slurry 410 according to some example embodiments, the soft particles and the nano-abrasive particles each have a Mohs hardness in the above ranges, so that the polishing slurry 410 according to some example embodiments including the soft particles and the nano-abrasive particles together can achieve high polishing rates while reducing or minimizing damage (e.g., surface scratches) and shape deformation of the structure to be polished. As a result, the performance of the polishing slurry 410 in facilitating polishing of a surface, with reduced, minimized, or prevented damage to the surface being polished may be improved.

A difference in Mohs hardness between the soft particles and the nano-abrasive particles (e.g., the difference in Mohs hardness between the Mohs hardness of the soft particles and the Mohs hardness of the abrasive particles) may be greater than or equal to about 1, for example, greater than or equal to about 1.5, greater than or equal to about 2, greater than or equal to about 2.5, greater than or equal to about 3, greater than or equal to about 3.5, greater than or equal to about 4, greater than or equal to about 4.5, greater than or equal to about 5.0, greater than or equal to about 5.5, or greater than or equal to about 6.0. Additionally, the difference in Mohs hardness between the soft particles and the abrasive particles in the polishing slurry 410 (e.g., the difference in Mohs hardness between the Mohs hardness of the soft particles and the Mohs hardness of the abrasive particles) may be less than or equal to about 10, less than or equal to about 9.0, less than or equal to about 8.0, or less than or equal to about 7.0. When the difference in Mohs hardness between the soft particles and nano-abrasive particles is within the above range, high-performance highly integrated semiconductor devices in which surface defects of semiconductor devices having a fine pitch structure of about 10 nm or less are reduced, minimized, or defects are eliminated can be manufactured based on one or more surfaces. As a result, the performance of the polishing slurry 410 in facilitating polishing of a surface, with reduced, minimized, or prevented damage to the surface being polished may be improved, and a semiconductor device having a high-performance, highly integrated semiconductor device including a structure having a fine pitch of about 10 nm or less with reduced, minimized, or absence of defects may be manufactured based on one or more surfaces of the semiconductor device being polished using the polishing slurry 410.

In some example embodiments, a nano-abrasive particle may be a particle having an average particle diameter in a range of about 1 nm to about 1000 nm. In the polishing slurry 410 according to some example embodiments, an average particle diameter of the nano-abrasive particles may be less than or equal to about 100 nanometers (nm), for example, less than or equal to about 90 nm, less than or equal to about 80 nm, less than or equal to about 70 nm, less than or equal to about 60 nm, less than or equal to about 50 nm, less than or equal to about 45 nm, less than or equal to about 40 nm, less than or equal to about 35 nm, less than or equal to about 30 nm, less than or equal to about 25 nm, less than or equal to about 20 nm, less than or equal to about 15 nm, less than or equal to about 10 nm, or less than or equal to about 5 nm, and in addition, an average particle diameter of the nano-abrasive particles may be greater than or equal to about 1 nm, for example, greater than or equal to about 2 nm, greater than or equal to about 3 nm, greater than or equal to about 4 nm, greater than or equal to about 5 nm, greater than or equal to about 10 nm, greater than or equal to about 15 nm, greater than or equal to about 20 nm, greater than or equal to about 25 nm, greater than or equal to about 30 nm, greater than or equal to about 35 nm, greater than or equal to about 40 nm, greater than or equal to about 45 nm, greater than or equal to about 50 nm, greater than or equal to about 60 nm, greater than or equal to about 70 nm, greater than or equal to about 80 nm, or greater than or equal to about 90 nm but is not limited to these ranges. If the size of the nano-abrasive particles is within the above range, surface defect problems such as surface scratches of the polishing object may not occur during a polishing process using a polishing slurry 410 including the nano-abrasive particles.

The nano-abrasive particles may have a spherical shape, but are not limited thereto. As previously defined, the average particle diameter of the spherical particle refers to a diameter (D₅₀) of a particle with a cumulative volume of 50 volume% in the particle size distribution.

In the polishing slurry 410 according to some example embodiments, when the size of the nano-abrasive particles is selected within the above range, the soft particles may be selected to have an average particle size larger than the particle size of the selected nano-abrasive particles, and the range of the average particle size is not particularly limited. When the size of the soft particles is larger than the size of the nano-abrasive particles, as described above, even if the soft particles alone do not have polishing ability, the large-sized soft particles can effectively transfer the load applied from the polishing head to the nano-abrasive particles, improving polishing efficiency and polishing rate. For example, an average particle size of the soft particles may be within a range of about 50 nm to about 20 µm, for example, greater than or equal to about 60 nm, greater than or equal to about 70 nm, greater than or equal to about 80 nm, greater than or equal to about 90 nm, greater than or equal to about 100 nm, greater than or equal to about 200 nm, greater than or equal to about 300 nm, greater than or equal to about 400 nm, greater than or equal to about 500 nm, greater than or equal to about 1 µm, greater than or equal to about 1.5 µm, greater than or equal to about 2 µm, greater than or equal to about 2.5 µm, greater than or equal to about 3 µm, greater than or equal to about 3.5 µm, greater than or equal to about 4 µm, greater than or equal to about 4.5 µm, greater than or equal to about 5 µm, greater than or equal to about 5.5 µm, greater than or equal to about 6 µm, greater than or equal to about 7 µm, greater than or equal to about 8 µm, greater than or equal to about 9 µm, greater than or equal to about 10 µm, greater than or equal to about 11 µm, greater than or equal to about 12 µm, greater than or equal to about 13 µm, greater than or equal to about 14 µm, greater than or equal to about 15 µm, greater than or equal to about 16 µm, greater than or equal to about 17 µm, greater than or equal to about 18 µm, or greater than or equal to about 19 µm and less than or equal to about 20 µm, for example, a particle size of the soft particles may be less than or equal to about 19 µm, less than or equal to about 18 µm, less than or equal to about 17 µm, less than or equal to about 16 µm, less than or equal to about 15 µm, less than or equal to about 14 µm, less than or equal to about 13 µm, less than or equal to about 12 µm, less than or equal to about 11 µm, less than or equal to about 10 µm, less than or equal to about 9 µm, less than or equal to about 8 µm, less than or equal to about 7 µm, less than or equal to about 6 µm, less than or equal to about 5 µm, less than or equal to about 4 µm, less than or equal to about 3 µm, less than or equal to about 2 µm, less than or equal to about 1 µm, less than or equal to about 0.5 µm, less than or equal to about 0.3 µm, or less than or equal to about 0.1 µm, but is not limited to these ranges.

The soft particles may have a spherical shape but are not limited thereto but have a shape close to the spherical shape, for example, an irregular polyhedron shape, wherein the soft particles in some example embodiments may not be plate-shaped particles.

The soft particles may include an organic material or an inorganic material.

If the soft particles include an inorganic material, the inorganic material may include a spherical inorganic material with a low Mohs hardness, for example, Mohs hardness of about 5 or less (e.g., about 0.1 to about 5, about 0.2 to about 5, about 0.3 to about 5, about 0.4 to about 5, or about 0.5 to about 5). The spherical inorganic material with a low Mohs hardness may include, for example, a spherical inorganic material having pores and thus a low apparent hardness, but is not limited thereto.

If the soft particles include an organic material, the organic material may include a polymer. Herein, because a Mohs hardness is a scale basically indicating a hardness of minerals, a hardness of a polymer needs to be converted to the Mohs hardness. According to known literature, a Mohs hardness of a polymer may be in a range of about 1.5 to about 2.5. Because nano-abrasive particles included in the polishing slurry 410 according to some example embodiments have a Mohs hardness of greater than about 5 (e.g., about 5 to about 10, about 5 to about 9, about 5 to about 8, or about 5 to about 7), most of polymers may be used as the soft particles in the polishing slurry 410 according to some example embodiments.

For example, the soft particles may include or may be polymer particles, for example, polystyrene, a styrene-based copolymer, poly(alkyl)(meth)acrylate, an acrylic copolymer, polyvinyl chloride, polyacetal, saturated polyester, polyamide, polyimide, poly(amide-imide) copolymer, polycarbonate, a phenoxy resin, polyolefin, an olefin-based copolymer, polyurea, polyurethane, a melamine resin, an epoxy resin, or any combination thereof, and is not limited thereto.

The soft particles may be selected from commercially available materials or materials synthesized in known methods. Because the soft particles in the polishing slurry 410 according to some example embodiments should have a zeta potential with a specific sign, a material having a zeta potential with such a sign may be selected, or the selected material may be modified in known methods to have such a zeta potential in the polishing slurry 410 according to some example embodiments.

In some example embodiments, the soft particles may include a polystyrene-based polymer or copolymer. When the soft particle includes a polystyrene-based polymer (homopolymer) or copolymer, its functional group can be modified to have a positive zeta potential or a negative zeta potential in a specific pH range. For example, as a polystyrene-based polymer or copolymer, polystyrene, poly(styrene-(vinylbenzyl)trimethylammonium chloride), etc. can be used as a material having a positive zeta potential, and as a material having a negative zeta potential, sodium polystyrene sulfonate (Polystyrene-NaSS), poly(styrene-divinylbenzene-sodium sulfonate) (Poly(styrene-divinylbenzene-NaSS)), etc. can be used, but are not limited to thereto.

The nano-abrasive particles may be selected from any abrasive particles that can be used in a chemical mechanical polishing process, and are not limited to a specific type of abrasive particles.

The nano-abrasive particles may include a metal oxide, a metal nitride, a metal fluoride, a metal carbide, or any combination thereof. For example, the metal oxide may include silicon oxide, cerium oxide, titanium oxide, zirconium oxide, aluminum oxide, molybdenum oxide, ruthenium oxide, tantalum oxide, tungsten oxide, or any combination thereof; the metal nitride may include silicon nitride, aluminum nitride, titanium nitride, boron nitride (cubic structure), or any combination thereof; the metal fluoride may include calcium fluoride (CaF₂), selenium fluoride (SeF₄), tellurium fluoride (TeF₄), or any combination thereof, and the metal carbide may include tantalum carbide, boron carbide, or any combination thereof.

Based on a total weight of the polishing slurry 410 according to some example embodiments, the nano-abrasive particles may be included in the polishing slurry 410 in an amount of about 0.01 wt% to about 15 wt%. For example, the nano-abrasive particles may be included in an amount of greater than or equal to about 0.01 wt%, greater than or equal to about 0.02 wt%, greater than or equal to about 0.03 wt%, greater than or equal to about 0.04 wt%, greater than or equal to about 0.05 wt%, greater than or equal to about 0.06 wt%, greater than or equal to about 0.07 wt%, greater than or equal to about 0.08 wt%, greater than or equal to about 0.09 wt%, greater than or equal to about 0.1 wt%, greater than or equal to about 0.15 wt%, greater than or equal to about 0.2 wt%, greater than or equal to about 0.4 wt%, greater than or equal to about 0.5 wt%, greater than or equal to about 1 wt%, greater than or equal to about 2 wt%, greater than or equal to about 3 wt%, greater than or equal to about 5 wt%, greater than or equal to about 10 wt%, greater than or equal to about 11 wt%, greater than or equal to about 12 wt%, greater than or equal to about 13 wt%, or greater than or equal to about 14 wt%. For example, the nano-abrasive particles may be included in an amount of less than or equal to about 14 wt%, less than or equal to about 13 wt%, less than or equal to about 12 wt%, less than or equal to about 11 wt%, less than or equal to about 10 wt%, less than or equal to about 9 wt%, less than or equal to about 8 wt%, less than or equal to about 7 wt%, less than or equal to about 6 wt%, less than or equal to about 5 wt%, less than or equal to about 4 wt%, less than or equal to about 3 wt%, less than or equal to about 2 wt%, or less than or equal to about 1 wt% based on a total weight of the polishing slurry 410 according to some example embodiments, but is not limited thereto.

By including nano-abrasive particles in the above range, the polishing slurry 410 according to some example embodiments can effectively polish a fine pitch structure while reducing or minimizing surface damage to the polishing object, and can also improve polishing rate and polishing efficiency. As a result, the performance of the polishing slurry 410 in facilitating polishing of a surface, with reduced, minimized, or prevented damage to the surface being polished may be improved, and a semiconductor device having a high-performance, highly integrated semiconductor device including a structure having a fine pitch of about 10 nm or less with reduced, minimized, or absence of defects may be manufactured with improved efficiency and/or reduced cost based on one or more surfaces of the semiconductor device being polished using the polishing slurry 410.

The soft particles may be included in the polishing slurry 410 in an amount of about 0.01 wt% to about 15 wt% based on a total weight of the polishing slurry 410 according to some example embodiments. For example, the soft particles may be included in an amount of greater than or equal to about 0.01 wt%, greater than or equal to about 0.02 wt%, greater than or equal to about 0.03 wt%, greater than or equal to about 0.04 wt%, greater than or equal to about 0.05 wt%, greater than or equal to about 0.06 wt%, greater than or equal to about 0.07 wt%, greater than or equal to about 0.08 wt%, greater than or equal to about 0.09 wt%, greater than or equal to about 0.1 wt%, greater than or equal to about 0.15 wt%, greater than or equal to about 0.2 wt%, greater than or equal to about 0.4 wt%, greater than or equal to about 0.5 wt%, greater than or equal to about 1 wt%, greater than or equal to about 2 wt%, greater than or equal to about 3 wt%, greater than or equal to about 5 wt%, greater than or equal to about 10 wt%, greater than or equal to about 11 wt%, greater than or equal to about 12 wt%, greater than or equal to about 13 wt%, or greater than or equal to about 14 wt%. In addition, the soft particles may be included in an amount of less than or equal to about 14 wt%, less than or equal to about 13 wt%, less than or equal to about 12 wt%, less than or equal to about 11 wt%, less than or equal to about 10 wt%, less than or equal to about 9 wt%, less than or equal to about 8 wt%, less than or equal to about 7 wt%, less than or equal to about 6 wt%, less than or equal to about 5 wt%, less than or equal to about 4 wt%, less than or equal to about 3 wt%, less than or equal to about 2 wt%, or less than or equal to about 1 wt% based on a total weight of the polishing slurry 410 according to some example embodiments.

By including soft particles in the above range, when the polishing slurry 410 according to some example embodiments is applied to a chemical mechanical polishing process, the soft particles are in good contact with the nano-abrasive particles, so that a polishing rate can be improved by effectively transmitting the load applied from the polishing head to the nano-abrasive particles. As a result, the performance of the polishing slurry 410 in facilitating polishing of a surface, with reduced, minimized, or prevented damage to the surface being polished may be improved, and a semiconductor device having a high-performance, highly integrated semiconductor device including a structure having a fine pitch of about 10 nm or less with reduced, minimized, or absence of defects may be manufactured with improved efficiency and/or reduced cost based on one or more surfaces of the semiconductor device being polished using the polishing slurry 410.

In the polishing slurry 410 according to some example embodiments, the soft particles and the nano-abrasive particles may be included in a weight ratio of about 0.1:1 to about 5:1. For example, the weight ratio of the soft particles and the nano-abrasive particles may be about 0.1:1 to about 4.5:1, about 0.2:1 to about 4.5:1, about 0.3:1 to about 4.5:1, about 0.5:1 to about 4.5:1, about 0.7:1 to about 4.5:1, about 0.7:1 to about 4:1, about 0.7:1 to about 3.8:1, about 0.7:1 to about 3.5:1, about 0.7:1 to about 3:1, about 1:1 to about 4.5:1, about 1:1 to about 4:1, about 1:1 to about 3.8:1, about 1:1 to about 3.5:1, about 1:1 to about 3:1, about 1.2:1 to about 4.5:1, about 1.4:1 to about 4.5:1, about 1.5:1 to about 4.5:1, about 1.5:1 to about 4:1, about 1.5:1 to about 3.5:1, about 1.5:1 to about 3:1, about 1.7:1 to about 4.5:1, about 2:1 to about 4.5:1, about 2:1 to about 4:1, about 2:1 to about 3.8:1, about 2:1 to about 3.5:1, about 2:1 to about 3:1, about 2.5:1 to about 4:1, about 2.5:1 to about 3.8:1, about 2.5:1 to about 3.5:1, or about 2.5:1 to about 3:1, but is not limited thereto.

In some example embodiments, in the polishing slurry 410 according to some example embodiments, the soft particles and the nano-abrasive particles may be included in a volume ratio of about 1:1 to about 30:1. For example, the weight ratio of the soft particles and the nano-abrasive particles may be about 1:1 to about 25:1, about 1:1 to about 23:1, about 1:1 to about 20:1, about 1:1 to about 18:1, about 1:1 to about 17:1, about 1:1 to about 15:1, about 1:1 to about 13:1, about 1:1 to about 12:1, about 1:1 to about 10:1, about 1:1 to about 8:1, about 1:1 to about 7:1, about 1:1 to about 5:1, about 1:1 to about 4.5:1, about 1:1 to about 4:1, about 1:1 to about 3.5:1, about 1:1 to about 3:1, about 1:1 to about 2.5:1, or about 1:1 to about 2:1, but is not limited thereto.

In the case that the weight ratio and/or volume ratio of the soft particles and nano-abrasive particles are within the above ranges, when a polishing slurry 410 containing these particles is applied to a chemical mechanical polishing process, the soft particles are in good contact with the nano-abrasive particles and the load applied from the polishing head is well transmitted to the nano-abrasive particles, thereby improving the polishing rate.

Based on a total weight of the polishing slurry 410 according to some example embodiments, the total amount of the nano-abrasive particles and the soft particles may be about 0.02 wt% to about 30 wt%. For example, the total amount of the nano-abrasive particles and the soft particles may be greater than or equal to about 0.02 wt%, greater than or equal to about 0.03 wt%, greater than or equal to about 0.04 wt%, greater than or equal to about 0.05 wt%, greater than or equal to about 0.06 wt%, greater than or equal to about 0.07 wt%, greater than or equal to about 0.08 wt%, greater than or equal to about 0.09 wt%, greater than or equal to about 0.1 wt%, greater than or equal to about 0.15 wt%, greater than or equal to about 0.2 wt%, greater than or equal to about 0.4 wt%, greater than or equal to about 0.5 wt%, or greater than or equal to about 1 wt% based on a total amount of polishing slurry. In addition, the total amount of the nano-abrasive particles and the soft particles may be included in an amount of less than or equal to about 30 wt%, less than or equal to about 28 wt%, less than or equal to about 25 wt%, less than or equal to about 23 wt%, less than or equal to about 20 wt%, less than or equal to about 18 wt%, less than or equal to about 15 wt%, less than or equal to about 12 wt%, less than or equal to about 10 wt%, less than or equal to about 9 wt%, less than or equal to about 8 wt%, less than or equal to about 7 wt%, less than or equal to about 6 wt%, or less than or equal to about 5 wt% based on a total amount of polishing slurry 410. A desired polishing rate and polishing efficiency may be obtained within the above range.

The polishing slurry 410 according to some example embodiments can be prepared by simply mixing the soft particles and the nano-abrasive particles having the same sign of zeta potential at a specific pH range. In some example embodiments, the polishing slurry 410 according to some example embodiments may be prepared by mixing the soft particles and the nano-abrasive particles having the same zeta potential at a specific pH.

The polishing slurry 410 according to some example embodiments may further include other components for forming the polishing slurry 410 in addition to the soft particles and the nano-abrasive particles. For example, the polishing slurry 410 may further include an additive, and the additive may be, for example, a chelating agent, an oxidizing agent, a surfactant, a dispersant, a pH adjusting agent, or any combination thereof, but is not limited thereto.

The chelating agent may be, for example, phosphoric acid, nitric acid, citric acid, malonic acid, a salt thereof, or any combination thereof, but is not limited thereto.

The oxidizing agent may be, for example, hydrogen peroxide, sodium hydroxide, potassium hydroxide, or any combination thereof, but is not limited thereto.

The surfactant may be an ionic or nonionic surfactant, and may be, for example, a copolymer of ethylene oxide, a copolymer of propylene oxide, an amine compound, or any combination thereof, but is not limited thereto.

The dispersant may promote dispersion of the soft particles and nano-abrasive particles and may include, for example, a water-soluble monomer, a water-soluble oligomer, a water-soluble polymer, a metal salt, or any combination thereof. A weight average molecular weight of the water-soluble polymer may be, for example, less than or equal to about 10,000 Dalton (Da), for example less than or equal to about 5,000 Da, for example less than or equal to about 3,000 Da and greater than or equal to about 1 Da, for example greater than or equal to about 10 Da, greater than or equal to about 100 Da, or greater than or equal to about 1,000 Da. The metal salt may be, for example, a copper salt, a nickel salt, a cobalt salt, a manganese salt, a tantalum salt, a ruthenium salt, or any combination thereof. The dispersant may be, for example, poly(meth)acrylic acid, (meth)acrylic maleic acid-maleic acid copolymer, acrylonitrile-butadiene-acrylic acid copolymer, carboxylic acid, sulfonic ester, sulfonic acid, phosphoric ester, cellulose, diol, a salt thereof, or any combination thereof, but is not limited thereto.

The pH adjusting agent may adjust the pH of the polishing slurry 410 and may include, for example, an acidic pH adjusting agent and a basic pH adjusting agent.

The acidic pH adjusting agent may include an inorganic acid, an organic acid, a salt thereof, or any combination thereof. The inorganic acid or the salt thereof may include, for example, nitric acid, hydrochloric acid, phosphoric acid, sulfuric acid, hydrofluoric acid, bromic acid, iodic acid, or a salt thereof, and the organic acid or the salt thereof may include, for example, formic acid, malonic acid, maleic acid, oxalic acid, adipic acid, citric acid, acetic acid, propionic acid, fumaric acid, lactic acid, salicylic acid, benzoic acid, succinic acid, phthalic acid, butyric acid, glutaric acid, glutamic acid, glycolic acid, lactic acid, aspartic acid, tartaric acid, or a salt thereof, but is not limited thereto.

The basic pH adjusting agent may include potassium hydroxide (KOH), sodium hydroxide (NaOH), ammonium hydroxide (NH₄OH), tetramethylammonium hydroxide (TMAH), trimethylamine (TMA), or any combination thereof, but is not limited thereto.

Each additive may be independently included in a small amount of, for example, about 1 ppm to about 100,000 ppm, but is not limited thereto.

The polishing slurry 410 may further contain a solvent capable of dissolving or dispersing the above components, and the solvent may be, for example, water. The water may be, for example, distilled and/or deionized water.

The aforementioned polishing slurry 410 can be applied when forming various structures, for example, in the polishing process of conductors such as metal wire, or shallow trench isolation (STI), or the polishing process of insulators such as insulating films. For example, the polishing slurry 410 according to some example embodiments may be used to polish a conductor such as a metal wire in a semiconductor substrate, and may be used to polish a conductor such as copper (Cu), tungsten (W), or an alloy thereof. Additionally, as an example, the polishing slurry according to some example embodiments may be used during the STI manufacturing process.

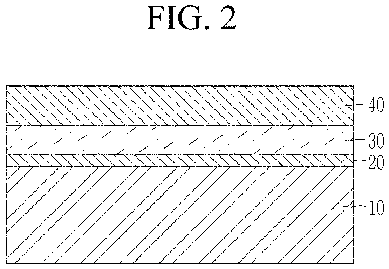

Hereinafter, referring to FIGS. 2 to 8, a process of manufacturing STI by using the polishing slurry 410 according to some example embodiments is described.

FIGS. 2, 3, 4, 5, 6, 7, and 8 are cross-sectional views showing the manufacturing process of shallow trench isolation (STI) according to some example embodiments. FIGS. 2 to 8 are cross-sectional views showing each step of the STI manufacturing process.

First, as shown in FIG. 2, a laminate in which a silicon oxide (SiO₂) film 20, a silicon nitride (SiN) film 30, and a photoresist 40 are sequentially stacked on a silicon substrate 10 is prepared. Because semiconductor substrates, for example, the silicon substrate 10 and the silicon nitride (SiN) film 30 have poor adherence, the silicon oxide (SiO₂) film 20 is formed therebetween. The silicon oxide (SiO₂) film 20 may be formed by oxidating the surface of the silicon substrate 10. Because the silicon nitride (SiN) film 30 is much harder than the silicon oxide (SiO₂) film 20, the silicon nitride (SiN) film 30 may play a role of protecting a lower layer from CMP slurry, when a chemical mechanical polishing (CMP) process is subsequently performed. The silicon nitride (SiN) film 30 may be formed in a chemical vapor deposition (CVD) method. The photoresist 40 may be formed by coating a photosensitive resin composition for a photoresist on the silicon nitride (SiN) film 30. A lower film may be patterned by using photoresist 40 through a photolithography process.

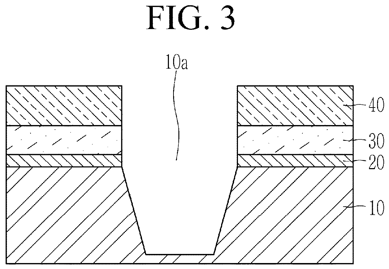

Subsequently, as shown in FIG. 3, after removing a portion of the photoresist 40 film through the photolithography process, through the removed portion of the photoresist 40 film, portions of the silicon nitride (SiN) film 30 and the silicon oxide (SiO₂) film 20 thereunder and even a portion of the silicon substrate 10 may be removed in an etching process to form a trench 10a in the silicon substrate 10.

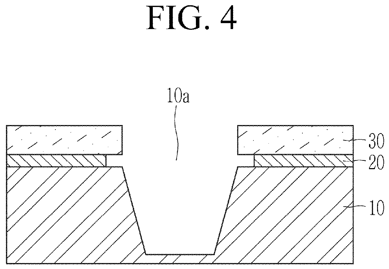

After forming the trench 10a, the remaining photoresist 40 is removed, as shown in FIG. 4. Most of the photoresist 40 may be removed through wet etching by using a chemical solution. Subsequently, the remaining photoresist is removed through a dry etching process using an oxygen (O₂) plasma.

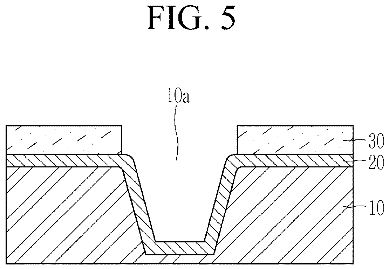

Then, as shown in FIG. 5, the surface of the trench 10a formed inside the silicon substrate 10 is oxidized through thermal oxidation to form the silicon oxide (SiO₂) film 20 on the inner surface of the trench 10a. This thermal oxidation process is a process for recovering ion damages generated in the dry etching process using an oxygen (O₂) plasma.

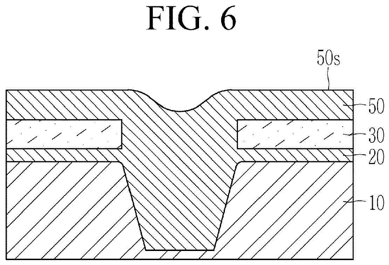

Subsequently, as shown in FIG. 6, the trench 10a is internally filled with oxides, wherein an oxide material having excellent gap-fill characteristics and generating no voids, for example, a TEOS (tetraethylorthosilicate) precursor may be used. TEOS is deposited inside the trench 10a and on the entire surface of a device by using a high-density plasma chemical vapor deposition (HDP CVD) method, etc., to form a silicon oxide (SiO₂) layer 50.

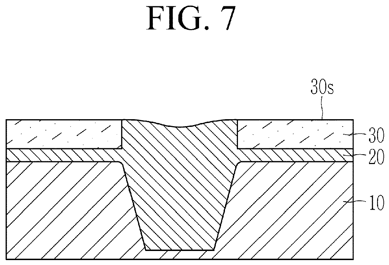

Subsequently, a chemical mechanical polishing (CMP) equipment 400 described below is used to polish the surface 50s of the laminate of FIG. 6 by using the CMP slurry (e.g., polishing slurry 410) according to some example embodiments, so that as shown in FIG. 7, the upper surface of the laminate may be planarized based on the surface 30s of the silicon nitride (SiN) film 30. This process may be performed by stopping the CMP process at a point when a polishing rate significantly decreases on the surface of the silicon nitride (SiN) film 30, which is much harder than the silicon oxide (SiO₂) film 20, as described above, when the CMP process is applied.

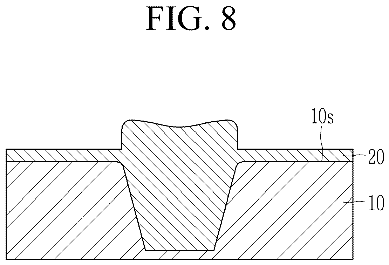

After the planarization process, the silicon nitride (SiN) film 30 remaining in the upper portion of the laminate, as shown in FIG. 7, may be removed, completing STI in which silicon oxide (SiO₂) is formed inside the trench formed in the silicon substrate 10 and on the surface 10s of the silicon substrate 10, as shown in FIG. 8.

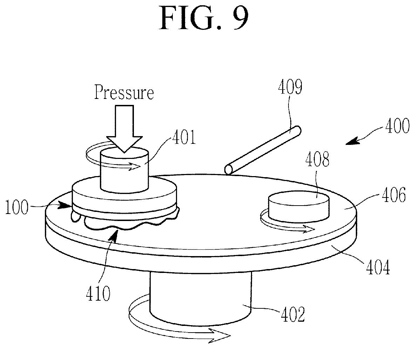

Hereinafter, with reference to FIG. 9, chemical mechanical polishing (CMP) equipment 400 that can be used to manufacture the STI will be described. FIG. 9 is a schematic view schematically showing example chemical mechanical polishing equipment according to some example embodiments.

The chemical mechanical polishing equipment 400 may include, for example, a polishing head 401; a lower base 402; a platen 404 rotatably provided on the upper surface of the lower base 402; a polishing pad 406 on the platen; a pad conditioner 408; and at least one polishing slurry supply device 409 disposed close to the polishing pad 406 where the polishing slurry supply device 409 is configured to supply the polishing slurry 410.

The platen 404 may be rotatably provided on the surface of the lower base 402. For example, the platen 404 may receive rotational power from a motor disposed in the lower base 402. Accordingly, the platen 404 may rotate around an imaginary rotation axis perpendicular to the surface of the platen 404. The imaginary rotation axis may be perpendicular to the surface of the lower base 402.

The platen 404 may include one or more supply lines through which a liquid (not shown) may be injected and discharged. For example, water may be injected and discharged into the platen 404 through the supply lines to adjust a temperature of the platen 404. For example, cooling water may be injected and discharged into the platen 404 through the supply lines and thus, lower the temperature of the platen 404 which is overheated. For example, hot water at a high temperature may be injected and discharged into the platen 404 through the supply lines, leading to increasing the temperature of the platen 404.

A polishing pad 406 may be disposed on the surface of the platen 404 to be supported by the platen 404. The polishing pad 406 may be rotated with the platen 404. The surface of the polishing pad 406 may be rough. The polishing surface may be in direct contact with the surface of the polishing object, for example, the semiconductor wafer 100 or the above-described laminate (e.g., the laminate as shown in any of FIGS. 2 to 8) for forming STI, and the surface may be mechanically polished. The polishing pad 406 may be a porous material having a plurality of microspaces, where a plurality of microspaces may accommodate the polishing slurry located within the interior of the polishing pad 406 and/or within microcavities of the polishing pad 406 that are exposed to the polishing surface of the polishing pad 406.

The pad conditioner 408 may be disposed adjacent to the polishing pad 406 and may adjust the condition of the polishing surface so that the surface of the object to be polished is effectively polished while the polishing process is performed.

The polishing slurry supply device 409 may be disposed adjacent to the polishing pad 406 and may supply polishing slurry 410 to the polishing pad 406. The polishing slurry supply device 409 may include a nozzle capable of supplying polishing slurry 410 onto the polishing pad 406 during the polishing process, and a voltage supply unit (not shown) capable of applying a particular (or, alternatively, predetermined) voltage to the nozzle. The polishing slurry 410 in the nozzle can be charged by the voltage applied from the voltage supply unit and discharged toward the polishing pad 406.

The chemical mechanical polishing may include, for example, arranging the surface of an object to be polished, for example, a semiconductor wafer 100 (e.g., the laminate as shown in FIG. 6, and in particular the surface 50s thereof), and a polishing pad 406 to face each other, supplying polishing slurry 410 from a polishing slurry supply device 409 between the surface of the semiconductor wafer 100 and the polishing pad 406; and applying pressure through the polishing head 401 to bring the surface of the semiconductor wafer 100 into contact with the polishing pad 406 (e.g., where the polishing slurry 410 may be at least partially between the surface of the semiconductor wafer 100 and the polishing pad 406) to perform polishing.

In some example embodiments, in the supplying of the polishing slurry, the polishing slurry 410 may be supplied (e.g., supplied from the polishing slurry supply device 409, supplied between the semiconductor wafer 100 and the polishing pad 406, or the like) at a rate of, for example, about 10 ml/min to about 300 ml/min, for example, about 10 ml/min to about 250 ml/min, or about 10 ml/min to about 200 ml/min, about 50 ml/min to about 250 ml/min, about 50 ml/min to about 200 ml/min, about 80 ml/min to about 250 ml/min, about 100 ml/min to about 200 ml/min, about 110 ml/min to about 180 ml/min, or about 120 ml/min to about 150 ml/min, but is not limited thereto.

In the step of performing polishing, for example, the surface of the semiconductor wafer 100 (which may include the laminate as shown in FIG. 6) is brought into contact with the polishing pad 406 by applying pressure through the polishing head 401, and polishing may be performed by mechanical friction by rotating the polishing pad 406 with respect to the surface of the semiconductor wafer 100. For example, in the step of performing polishing (e.g., concurrently with the polishing of the surface of the semiconductor wafer 100 proximate to and/or facing the polishing pad 406), a pressure of about 1 psi to about 10 psi, for example, about 1 psi to about 8 psi, about 2 psi to about 7 psi, about 2 psi to about 6 psi, about 2 psi to about 5 psi, or about 3 psi to about 4 psi may be applied between the polishing pad 406 and the object to be polished through the polishing head 401 such that the pressure is applied to a surface of the object to be polished. For example, the pressure may be applied between the polishing pad 406 and the semiconductor wafer 100 such that the pressure is applied to the surface of the semiconductor wafer 100 proximate to and/or facing the polishing pad 406.

In some example embodiments, the semiconductor wafer 100 may include metal wire proximate to the surface of the semiconductor wafer 100 that is proximate to and/or facing the polishing pad 406, and the polishing of the surface of the semiconductor wafer 100 may polish the metal wire.

Although the STI manufacturing method according to an example has been described above, example embodiments are not limited thereto and can be applied to semiconductor devices of various structures. A method of manufacturing such a semiconductor device includes arranging a surface of a semiconductor substrate and a surface of a polishing pad proximate to the other, supplying a polishing slurry 410 according to some example embodiments between the semiconductor substrate and the polishing pad, and polishing the surface of the semiconductor substrate by contacting the surface of the semiconductor substrate with the surface of the polishing pad.

Descriptions herein with regard to a semiconductor wafer 100 may be applied equally and interchangeably to a semiconductor substrate, a laminate, or the like.

As described herein, a "semiconductor substrate" may include one or more structures of a semiconductor device, including for example a laminate which may include one or more of the silicon oxide (SiO₂) film 20, the silicon nitride (SiN) film 30, the photoresist 40, and/or the silicon oxide (SiO₂) layer 50.

As described herein, a surface of a "semiconductor substrate" may include one or more surfaces of one or more structures of a semiconductor device, including for example one or more surfaces of the silicon oxide (SiO₂) film 20, the silicon nitride (SiN) film 30, the photoresist 40, and/or the silicon oxide (SiO₂) layer 50 (e.g., one or more of surfaces 10s, 30s, 50s, or the like).

As described herein, the step of performing polishing, performing polishing of the surface of a "semiconductor substrate," or the like may be understood to include performing a polishing (e.g., as part of planarization) of one or more surfaces of the semiconductor device, such as the surface of an interlayer insulating film, a barrier layer, and/or a metal film.

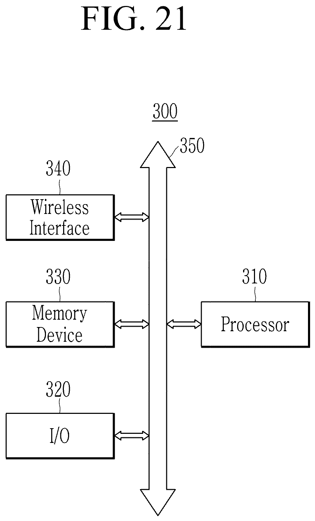

In some example embodiments, one or more semiconductor devices (e.g., a semiconductor wafer, one or more semiconductor chips which may be singulated from the semiconductor wafer, or the like) may be manufactured based on performing the polishing. Such one or more semiconductor devices may be incorporated (e.g., applied) into the assembly of an electronic device, including for example an electronic device as shown in FIG. 21. As a result, an electronic device configured to have improved performance and integration (e.g., improved compactness) may be manufactured based on being manufactured to include one or more high-performance, highly integrated semiconductor device (e.g., having a structure having a fine pitch of about 10 nm or less) based on having structure surfaces polished using a polishing slurry 410 according to any of the example embodiments.

FIG. 21 is a schematic block diagram of an electronic device 300 according to some example embodiments.

Referring to FIG. 21, an electronic device 300 may include a processor 310, an input/output device (I/O) 320, a memory device 330, and a wireless interface 340, which are respectively connected to one another through a bus 350. In some example embodiments, one or more of the input/output device 320 or the wireless interface 340 may be omitted from the electronic device 300. At least one of the processor 310, the input/output device 320, the memory device 330, or the wireless interface 340 may include one or more semiconductor devices manufactured according to any of the example embodiments (e.g., using a polishing slurry 410 according to any of the example embodiments). In some example embodiments, the electronic device 300 may be configured to control various equipment for manufacturing a semiconductor device (including, for example, controlling some or all of the chemical mechanical polishing equipment 400) and/or various equipment for manufacturing an electronic device to cause the various equipment to manufacture a semiconductor device, an electronic device including same, or the like.

The processor 310 may include at least one of a microprocessor, a digital signal processor, or a processing device similar thereto. The input/output device 320 may include at least one of a keypad, a keyboard, or a display. The memory device 330 may include a non-transitory computer readable medium configured to store a program of instructions (e.g., a solid state drive memory device). The memory device 330 may be used to store commands executed by the processor 310. For example, the memory device 330 may be used to store user data. The electronic device 300 may use the wireless interface 340 to transmit/receive data over a wireless communication network. The wireless interface 340 may include an antenna and/or a wireless transceiver.

The electronic device 300 and/or any portion thereof (e.g., the processor 310, the memory device 330, the input/output device 320, the wireless interface 340, any portion thereof, or the like) may include, may be included in, and/or may be implemented by one or more instances of processing circuitry such as hardware including logic circuits; a hardware/software combination such as a processor executing software; or any combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a solid state drive (SSD) device, storing a program of instructions, and a processor (e.g., a CPU) configured to execute the program of instructions to implement the functionality and/or methods performed by some or all of the electronic device 300 and/or any equipment and/or methods implemented and/or controlled thereby (e.g., to perform some or all of the method shown in FIGS. 2-8, for example based on controlling the chemical mechanical polishing equipment 400 shown in FIG. 9).

Hereinafter, some example embodiments are illustrated in more detail with reference to examples. However, the scope of claims is not limited to these examples.

### Examples

### Reference Example 1: Measurement of Polishing Rates of Slurries Including Nano-abrasive Particles or Soft Particles Individually

Polystyrene particles having an average particle size of about 92 nm, a Mohs hardness of about 1.5 to 2.5, to which a hardness is converted, and an approximately spherical shape are prepared as soft particles. As nano-abrasive particles, two types of ceria (CeO₂) having different average particle diameters (D₅₀ = 15 nm or 25 nm), manufactured by Ditto Technology (Mohs hardness: 7.5 to 8), are prepared.

All slurries include water as a solvent, and the soft particles and the nano-abrasive particles are respectively used in an amount of 0.2% based on a total weight of each slurry, and pH is adjusted to 4 by adding nitric acid and ammonia water thereto. In addition, CTAB (cetyltrimethylammonium bromide) as an additive is added by 0.5% of a ceria mass.

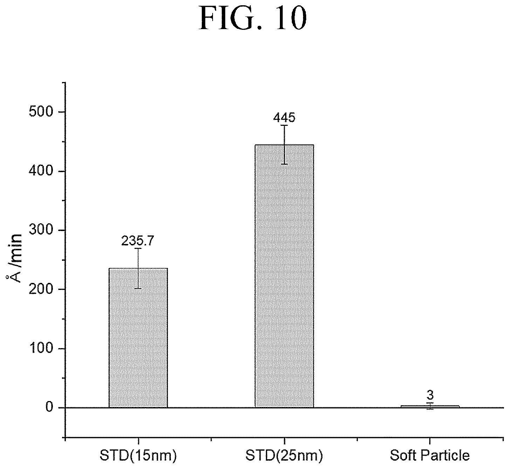

Each slurry prepared as described above is used to polish a semiconductor wafer according to a polishing rate evaluation method as below, and the results are shown in FIG. 10.

As shown in FIG. 10, as for slurries using two types of ceria with different particle sizes alone (STD (15 nm) and STD (25 nm)), one slurry using ceria with a larger particle size (STD (25 nm)) exhibits a much higher polishing rate than the other slurry using ceria with a smaller particle size (STD (15 nm), but a slurry including the soft particles alone exhibits almost no polishing. In other words, the soft particles, which are used alone, exhibit substantially no polishing performance due to a low Mohs hardness.

### (Evaluation of Polishing Rate (MRR, material removal rate))

A 40 mm X 40 mm sized silicon wafer coated with a silicon oxide (SiO₂) film is used as a polishing wafer, and the polishing rate of the silicon oxide film is evaluated using each polishing slurry using the following polishing conditions.

The thickness of the silicon oxide film before polishing and the thickness of the silicon oxide film after polishing are measured, and the change in thicknesses (Å) of the silicon oxide film per unit time (1 minute) of polishing is taken as the MRR value. For thickness measurement, the center portion of the silicon oxide film is measured 5 times using a reflectometer (ST5030-SL, K-MAC) and the average value is used.

The polishing conditions are as follows:
(1) CMP equipment: POLI-400 (GnP Tech. Co.)
(2) Polishing pad: IT-2000 (KPX Chemical Co.)
(3) Rotation speed of polishing head: 130 rpm
(4) Polishing platen rotation speed: 130 rpm
(5) Applied pressure: 5.5 psi
(6) Polishing slurry supply rate: 150 ml/min.

### Examples 1 to 3: Measurement of Polishing Rates of Slurries Including Both Nano-abrasive Particles and Soft Particles

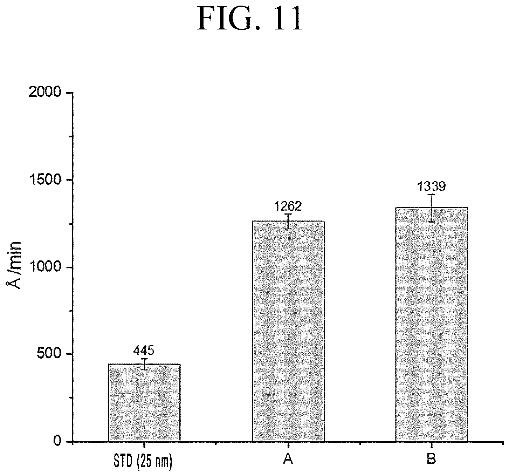

Slurry A was prepared by mixing ceria (0.2 wt%) having a size of 25 nm used in Reference Example 1 and polystyrene particles (0.25 wt%) having an average size of 92 nm and a positive zeta potential at pH 4, and Slurry B was prepared by mixing the same ceria as above (0.2 wt%) and polystyrene particles (0.25 wt%) having a different average particle size of 107 nm and the same positive zeta potential at pH 4. Then, Slurry A and Slurry B were respectively measured with respect to a polishing rate by using the polishing rate evaluation method as described above, and the results are shown, along with corresponding results for the Reference Example 1 slurry STD (25 nm) which is illustrated and described with reference to FIG. 10, in FIG. 11 (Example 1).

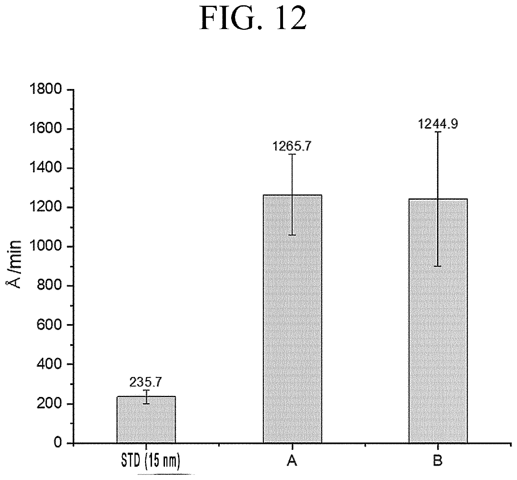

In addition, Slurry A was prepared by mixing ceria (0.2 wt%) having a size of 15 nm used in Reference Example 1 and polystyrene particles (0.5 wt%) having an average size of 130 nm and a positive zeta potential at pH 4, and Slurry B was prepared by mixing the same ceria as above (0.2 wt%) and polystyrene particles (0.5 wt%) having a different average particle size of 157 nm and the same positive zeta potential at pH 4. Then, Slurry A and Slurry B were respectively measured with respect to a polishing rate by using the polishing rate evaluation method as described above, and the results are shown, along with corresponding results for the Reference Example 1 slurry STD (15 nm) which is illustrated and described with reference to FIG. 10, in FIG. 12 (Example 2).

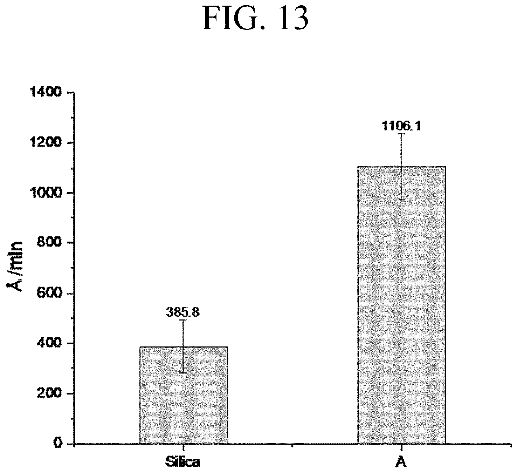

In addition, similar to Reference Example 1, a slurry including 8 wt% of silica having a particle size of 7 nm alone was prepared, and Slurry A was prepared by mixing 8 wt% of the same silica as above and 3.6 wt% of polystyrene particles having a negative zeta potential at pH 4 was prepared. Then, the slurry including the silica alone and Slurry A were measured with respect to a polishing rate by using the same method as above, and the results are shown in FIG. 13 (Example 3).

As shown in FIGS. 11 to 13, compared to the cases of including nano-abrasive particles (ceria or silica) alone, the slurries including the nano-abrasive particles along with the soft particles (polystyrene particles) having the same zeta potential sign as each of the nano-abrasive particles, wherein the soft particles do not exhibit polishing performance alone, exhibit significantly improved polishing rate.

### Example 4: Measurement of Polishing Effects According to Amount of Soft Particles

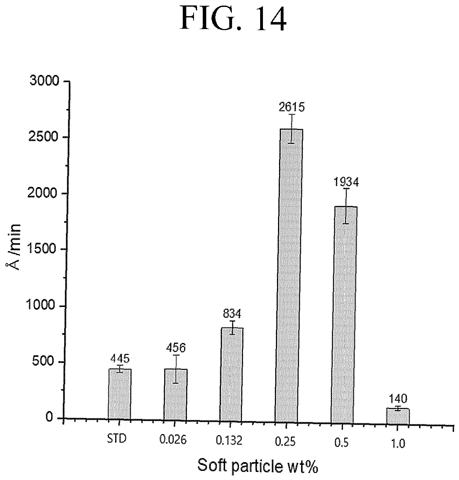

A slurry (STD: Standard) including 0.2 wt% of ceria particles with a size of 25 nm used in Reference Example 1 (e.g., STD (25 nm) as described herein) and having pH adjusted to 4 was prepared. In addition, slurries including the same ceria particles as above and polystyrene particles having an average particle size of 83 nm and a positive zeta potential at pH 4 in each amount of 0.026 wt%, 0.132 wt%, 0.25 wt%, 0.5 wt%, and 1.0 wt%, respectively, were prepared. Then, the slurries were measured with respect to a polishing rate by using the method as described above, and the results are shown in FIG. 14.

As shown in FIG. 14, the more the polystyrene particles are added within a particular (or, alternatively, predetermined) content, the higher polishing rate is obtained, but if the polystyrene particles are added beyond a particular (or, alternatively, predetermined) content, the polishing rate rather decreased.

### Example 5: Comparison of Effects Depending on Whether the Zeta Potential Sign of Soft Particles and Nano-abrasive Particles is the Same or Not

A slurry (Positive A) including 0.026 wt% of polystyrene particles having a positive zeta potential at pH 4 and an average particle size of 86 nm and 0.2 wt% of ceria having a particle size of 25 nm, and a slurry (Positive B) which is the same as the Positive A but changing only the average particle size of the polystyrene particles to 128 nm were prepared.

In addition, a slurry (Negative A) including 0.026 wt% of polystyrene particles surface-modified to have a negative zeta potential instead of a positive zeta potential at pH 4 and having an average particle size of 83 nm and 0.2 wt% of ceria having a particle size of 25 nm, and a slurry (Negative B) which is the same as the Negative A but changing only the average size of the polystyrene particles to 92 nm were prepared.

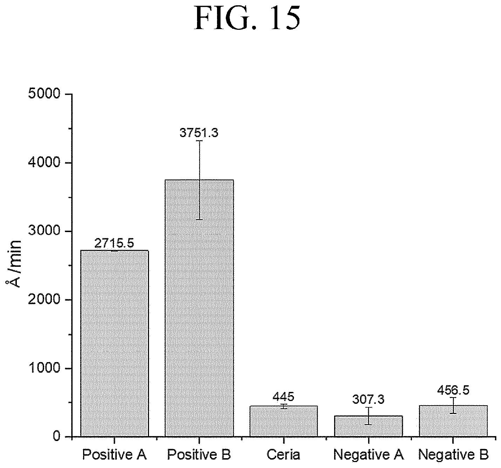

The Positive A, Positive B, Negative A, and Negative B slurries and a slurry including 0.2 wt% of ceria particles with a size of 25 nm alone without the soft particles such as polystyrene particles and the like were evaluated with a polishing rate by using the method as described above, and the results are shown in FIG. 15.

As shown in FIG. 15, the Positive A and Positive B slurries, in which ceria exhibiting a positive zeta potential at pH 4 and polystyrene soft particles having the same zeta potential sign as that of the ceria are combined, compared to the slurry including ceria alone, exhibit polishing rates increased to about 6 times and about 9 times, respectively. However, the Negative A and Negative B slurries, in which polystyrene soft particles having an opposite zeta potential sign to that of ceria are included, exhibit a similar polishing rate to that of the slurry including ceria alone (in case of Negative B), or a rather lower polishing rate than that of the slurry including ceria alone (in case of Negative A).

Accordingly, the case of further including soft particles having the same sign of zeta potential as the nano-abrasive particles according to some example embodiments, compared to the case of including abrasive particles having a very small particle size alone, exhibits a significantly improved polishing rate.

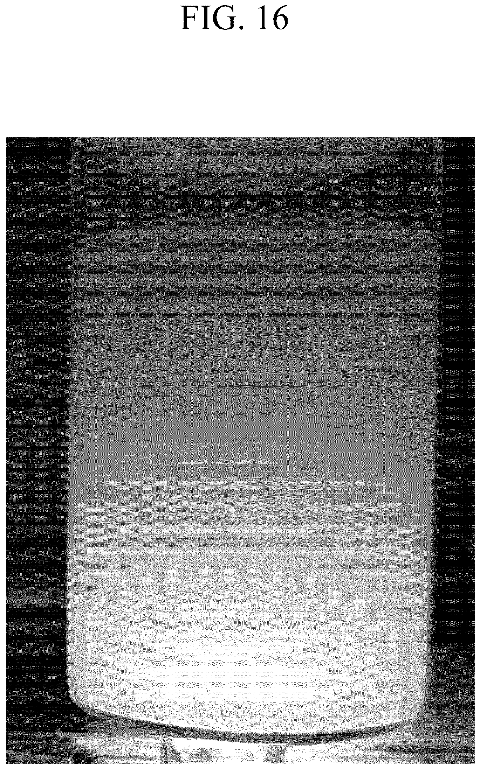

In addition, a photograph of the Negative A slurry is shown in FIG. 16. Referring to FIG. 16, the Negative A slurry in which soft particles exhibiting an opposite sign of zeta potential to that of ceria is added looks cloudy as the nano-abrasive particles (ceria) and the soft particles (polystyrene particles) are adsorbed with each other to form precipitates.

The above trend is also confirmed in slurries using silica particles.

The silica particles exhibit a negative zeta potential at pH of about 2.5 or higher. If a soft particle exhibiting a positive zeta potential within the same pH range is added to these silica particles, precipitates are formed due to the adsorption of the two types of particles.

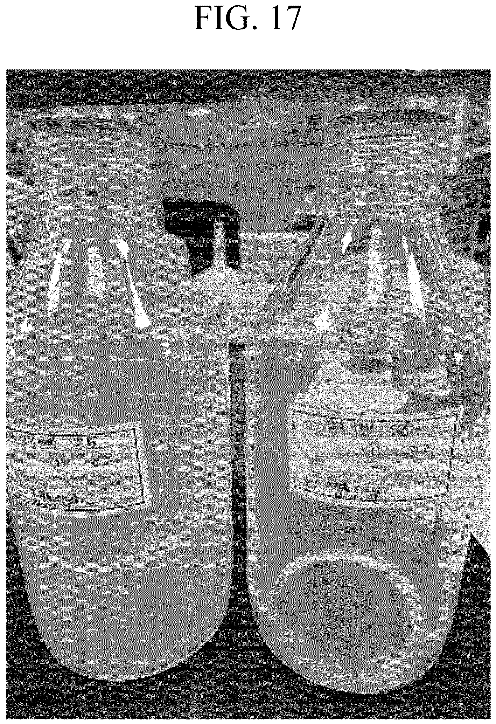

Specifically, as shown in FIG. 17, if 3.58 wt% of polystyrene particles exhibiting a positive zeta potential at the same pH and having an average size of 88 nm is added to a bottle containing an aqueous solution including silica (8.8 wt%) with a particle size of 7 nm, precipitates are stuck onto the wall of the bottle after pouring out the corresponding solution, making the wall of the bottle look cloudy (the left photograph of FIG. 17). However, if polystyrene particles (3.58 wt%) having an average size of 88 nm and exhibiting a negative zeta potential at the same pH were added to the aqueous solution including the silica particles (average size of 7 nm, 8.8 wt%), the wall of the bottle kept looking transparent (the bottle on the right side of the photograph of FIG. 17).

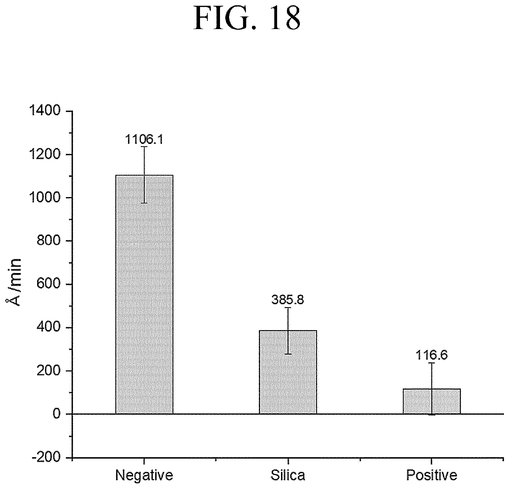

In addition, the (Negative) slurry prepared by adding polystyrene particles (average size of 88 nm, 3.58 wt%) having a negative zeta potential to the silica (average size of 7 nm, 8.8 wt%), and the (Positive) slurry prepared by adding polystyrene particles (average size of 88 nm, 3.58 wt%) having a positive zeta potential to the silica (average size of 7 nm, 8.8 wt%) are evaluated with respect to a polishing rate, and the results are shown in FIG. 18. In FIG. 18, the amount of silica contained in "Silica" that contains silica alone is 8.8 wt%. In FIG. 18, similar to FIG. 15, the Negative slurry in which the polystyrene particles having the same sign of zeta potential as the silica particles are added exhibits an almost 4 times increased polishing rate. However, the Positive slurry in which soft particles having the opposite sign of zeta potential are added to the silica exhibits a 1/3 or so reduced polishing rate to that of a slurry including silica alone.

### Example 6: Comparison of Effect of Reducing Surface Scratches Due to Addition of Soft Particles

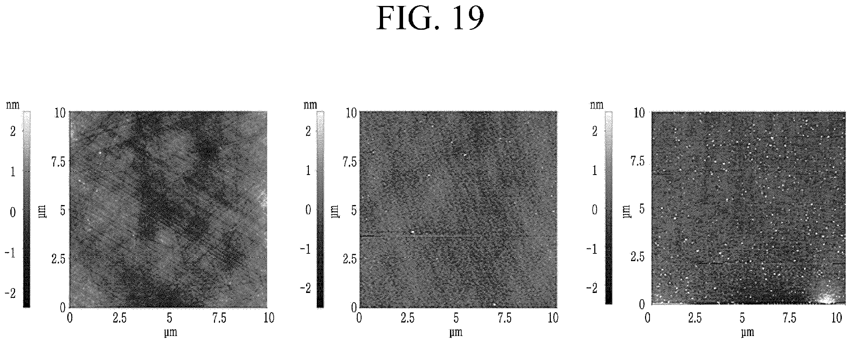

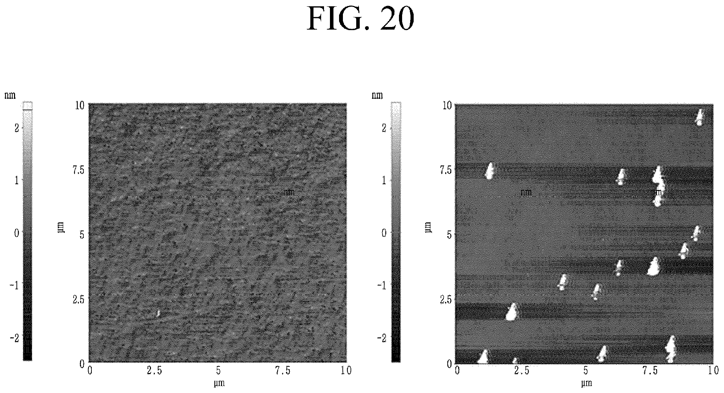

Compared to the case of including ceria having a particle size of 25 nm and 50 nm alone or silica having a particle size of 7 nm alone, the cases of adding soft polystyrene particles to the ceria or silica are checked with respect to presence or absence of scratches on a surface of the polishing object by surface-analyzing the surface of polished wafer through AFM (Atomic Force Microscopy), and the results are shown in FIGS. 19 and 20.

As shown in FIG. 19, if particle size of the ceria is reduced from 50 nm (refer to the left photograph of FIG. 19, in which the amount of ceria is 0.2 wt%) to 25 nm (refer to the middle photograph of FIG. 19, in which the amount of ceria is 0.2 wt%), the surface scratches are reduced. On the other hand, even if ceria with a size of 25 nm (0.2 wt%) is mixed with polystyrene particles with an average size of 83 nm (refer to the right photograph of FIG. 19, in which the amount of polystyrene particles is 0.026 wt%), scratches are generated at a similar level to the case of using the ceria (0.2 wt%) with a size of 25 nm alone. In other words, even if soft particles with a large size are added, the surface scratches are not increased due to the soft particles.

In addition, referring to FIG. 20, a slurry including silica with a size of 7 nm alone (refer to the left photograph of FIG. 20, in which the amount of silica is 8.8 wt%) and a slurry in which polystyrene particles (3.58 wt%) with an average size of 100 nm are included along with the silica (refer to the right photograph of FIG. 20, in which the amount of ceria is 0.2 wt%) exhibit generation of surface scratches at a similar level. In other words, even if soft particles with a large particle size are added, the surface scratch generation is not increased by the soft particles.

As described above, the polishing slurry according to some example embodiments, which includes nano-abrasive particles, as well as soft particles that substantially have no polishing performance due to a lower Mohs hardness than the nano-abrasive particles and have the same sign of zeta potential as that of the nano-abrasive particles in a specific pH range, exhibits an excellent effect of significantly improving a polishing rate, despite using the abrasive particles with a very small particle size. Accordingly, the polishing slurry according to some example embodiments may be used to rapidly polish a structure with a fine pitch structure without surface damages.

While the inventive concepts have been described in connection with what is presently considered to be practical example embodiments, it is to be understood that the inventive concepts are not limited to such example embodiments. On the contrary, the scope of the inventive concepts is intended to cover various modifications and equivalent arrangements included within the scope of the appended claims.

## Claims

1. A polishing slurry, comprising:
nano-abrasive particles having a Mohs hardness greater than 5; and
soft particles having a Mohs hardness lower than the Mohs hardness of the nano-abrasive particles,
wherein the nano-abrasive particles and the soft particles in the polishing slurry have a same sign of zeta potentials as each other.

2. The polishing slurry of claim 1, wherein the soft particles include polymer particles.

3. The polishing slurry of claim 1 or 2, wherein a difference in Mohs hardness between the Mohs hardness of the soft particles and the Mohs hardness of the nano-abrasive particles is greater than or equal to 1.

4. The polishing slurry of any preceding claim, wherein the soft particles have a larger average particle size than the nano-abrasive particles.

5. The polishing slurry of any preceding claim, wherein an average particle size of the nano-abrasive particles is less than or equal to 100 nanometers.

6. The polishing slurry of any preceding claim, wherein an average particle size of the soft particles is 50 nm to 20 µm.

7. The polishing slurry of any preceding claim, wherein the nano-abrasive particles and the soft particles in the slurry have a same zeta potential as each other.

8. The polishing slurry of any preceding claim, wherein the soft particles comprise polystyrene, a styrene-based copolymer, poly(alkyl)(meth)acrylate, an acrylic copolymer, polyvinyl chloride, polyacetal, saturated polyester, polyamide, polyimide, a poly(amide-imide) copolymer, polycarbonate, phenoxy resin, polyolefin, an olefin-based copolymer, polyurea, polyurethane, melamine resin, an epoxy resin, or any combination thereof.

9. The polishing slurry of any preceding claim, wherein the nano-abrasive particles comprise a metal oxide, a metal nitride, a metal fluoride, a metal carbide, or any combination thereof, and optionally wherein:
the metal oxide comprises silicon oxide, cerium oxide, titanium oxide, zirconium oxide, aluminum oxide, molybdenum oxide, ruthenium oxide, tantalum oxide, tungsten oxide, or any combination thereof;
the metal nitride comprises silicon nitride, aluminum nitride, titanium nitride, boron nitride, or any combination thereof;
the metal fluoride comprises calcium fluoride CaF₂, selenium fluoride SeF₄, tellurium fluoride TeF₄ or any combination thereof; and
the metal carbide comprises tantalum carbide, boron carbide, or any combination thereof.

10. The polishing slurry of any preceding claim, wherein the soft particles are included in the polishing slurry in an amount of 0.01 wt% to 15 wt%, and/or wherein the nano-abrasive particles are included in the polishing slurry in an amount of 0.01 wt% to 15 wt%, based on a total weight of the polishing slurry.

11. The polishing slurry of any preceding claim, wherein the soft particles and the nano-abrasive particles are included in a weight ratio of 0.1:1 to 5:1 in the polishing slurry, and/or, wherein the soft particles and the nano-abrasive particles are included in a volume ratio of 1:1 to 30:1 in the polishing slurry.

12. The polishing slurry of claim 1, wherein the soft particles and/or the nano-abrasive particles are spherical.

13. The polishing slurry of any preceding claim 1, wherein in the polishing slurry,
both the soft particles and the nano-abrasive particles have positive zeta potentials, or both the soft particles and the nano-abrasive particles have negative zeta potentials.

14. A method of manufacturing a semiconductor device, the method comprising:
arranging a surface of a semiconductor substrate and a surface of a polishing pad proximate to each other,
supplying the polishing slurry of any preceding claim between the semiconductor substrate and the polishing pad, and
polishing the surface of the semiconductor substrate based on contacting the surface of the semiconductor substrate with the surface of the polishing pad.

15. The method of claim 14, wherein the supplying of the polishing slurry between the semiconductor substrate and the polishing pad is conducted at a rate of 10 ml/min to 300 ml/min, and/or, wherein the polishing of the surface of the semiconductor substrate is conducted concurrently with a pressure being applied to the surface of the semiconductor substrate, the pressure being 1 psi to 10 psi.
